# EUROPEAN PATENT SPECIFICATION

(11) **EP 1 566 888 B1**
(45) Date of publication and mention of the grant of the patent: **23.05.2007**
(21) Application number: 04425100.7
(22) Date of filing: 18.02.2004
(51) Int. Cl.: H03K 3/03

(54) **Clock-pulse generator circuit**
Taktimpulsgenerator
Générateur d'impulsions d'horloge

(43) Date of publication of application: 24.08.2005
(73) Proprietor: STMicroelectronics S.r.l., 20041 Agrate Brianza (Milano) (IT)
(72) Inventor: Confalonieri, Pierangelo, 28202 Caponago (Milano) (IT); Zamprogno, Marco, 20031 Cesano Maderno (Milano) (IT); Nagari, Angelo, 27024 Cilavegna (Pavia) (IT)
(74) Representative: Siniscalco, Fabio

(56) References cited:
- EP-A- 0 901 226
- US-A- 4 565 976
- US-A- 5 357 204
- US-A- 5 416 436
- US-B1- 6 362 694
- PATENT ABSTRACTS OF JAPAN vol. 1996, no. 08, 30 August 1996 (1996-08-30) -& JP 08 102643 A (ASAHI KASEI MICRO SYST KK), 16 April 1996 (1996-04-16)
- U.TIETZE, CH.SCHENK: "Halbleiter-Schaltungstechnik 10.Auflage" 1993, SPRINGER VERLAG 561846 , XP002288569 * page 232 - page 236; figures 10.3,10.10 *

## Description

The present invention relates in general to timing circuits and, more particularly, to a clock-pulse generator of the type defined in the preamble of Claim 1.

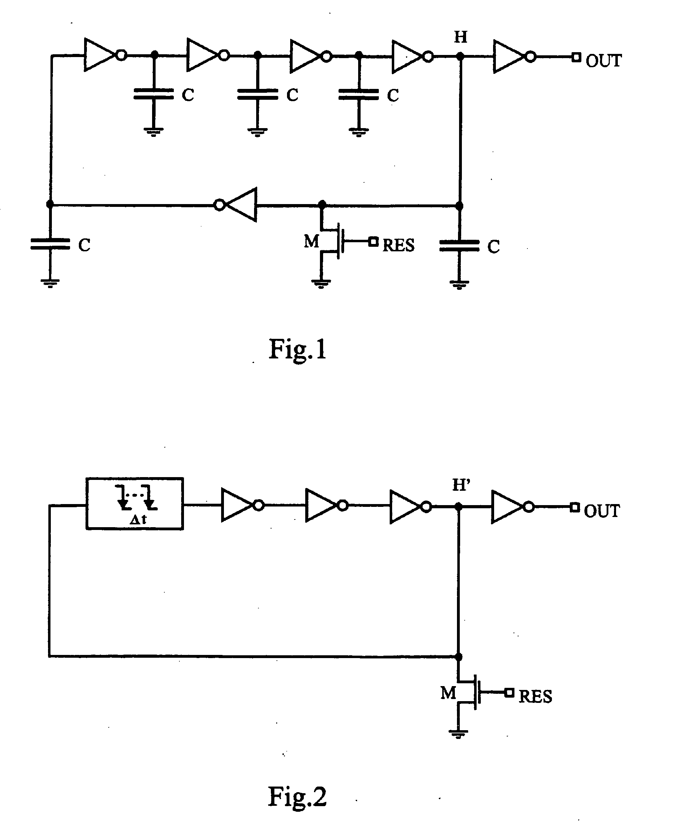

A clock-pulse generator frequently utilized in digital circuits is the oscillator shown in Figure 1. It consists of an odd number of inverter elements connected to each other in the form of a ring and having a given input capacitance. A node H of the ring is connected to an output buffer, in this example another inverter, whose output OUT is the output of the generator. Given its input capacitance, each inverter constitutes a delay cell. With a view to permitting the activation and deactivation of the generator, the circuit is provided with an electronic switch M, in this example an N-channel MOS transistor, connected between the node H and ground and controlled by a signal RES that can assume either one or the other of two voltage values, typically those of the supply source of the circuit, corresponding to the logic states 0 and 1. When the switch is closed (RES=1), the generator is deactivated and the output OUT is in the logic state 0 (OUT=0). When the switch is open (RES=0), the oscillator can function and on the output (OUT) of the buffer there forms a train of pulses that, in the steady state, vary between 0 and 1 with a period 2n*dt, where n is the number of inverters in the ring and dt is the propagation delay of one cell. The duty cycle of the pulse train is typically 50% and is not easy to modify. This circuit has the drawback that, when the oscillator is started, its output, prior to attaining steady conditions, is subject to a transient during which both the amplitude and the frequency of the pulse train will vary. Consequently, whenever the output OUT has to be used for operations that call for the steady state oscillation frequency, one necessarily has to wait for the end of the transient.

Figure 2 illustrates another known oscillator that comprises an odd number of inverting logic elements and a delay element connect in the form of a ring. The delay element is made in such a manner as to respond to a pulse at its input with a predetermined delay Δt with respect to the trailing edge of the input pulse and practically without delay with respect to the leading edge of this input pulse. A node H' of the ring is connected to an output buffer, once again an inverter in this example, whose output is the output OUT of the generator. In order to permit activation and deactivation of the oscillator, the circuit is again provided with an electronic switch, an N-channel MOS transistor again indicated by M, connected between the node H' and ground and controlled by a signal RES as in the circuit of Figure 1. By this circuit, when a signal RES=0 causes transistor M to block, the oscillation begins practically without transients, so that the output OUT can be used immediately. As a general rule, however, the output signal has a very asymmetric duty cycle, because the time in which it is in the state 1 and the time in which it is in the state 0 are determined by delays that, in the greater part of practical applications, are very different from each other; in fact, we are here concerned with a relatively long delay due to the delay element and a relatively short delay deriving from the sum of the very brief switching delays of the inverters. The delay of the delay element can be easily modified, but that of the inverters is practically invariable, so that the duty cycle can be set to about 50% only for very high oscillation frequencies.

Another example of a ring oscillator comprising inverting elements is disclosed in figure 5B of document US 4,565,976.

The principal object of the present invention is to make available a clock-pulse generator circuit that is devoid of start-up transients and produces clock pulses with a duty cycle that can easily be set to any desired value.

This object is attained by realizing the circuit defined and characterized in general terms in Claim 1, while some particular embodiments thereof are defined by the dependent claims.

The invention will be more readily understood from the following detailed description of a particular embodiment and some variants, the description making reference to the attached drawings, of which
Figures 1 and 2 show the layout of two known oscillators,
Figure 3 shows the layout of a clock-pulse generator in accordance with a particular embodiment of the invention,
Figure 4 shows some waveforms that illustrate the functioning of the circuit of Figure 3, and
Figures 5, 6, 7 and 8 show the layouts of some delay elements that can be used in the pulse generator in accordance with the invention.

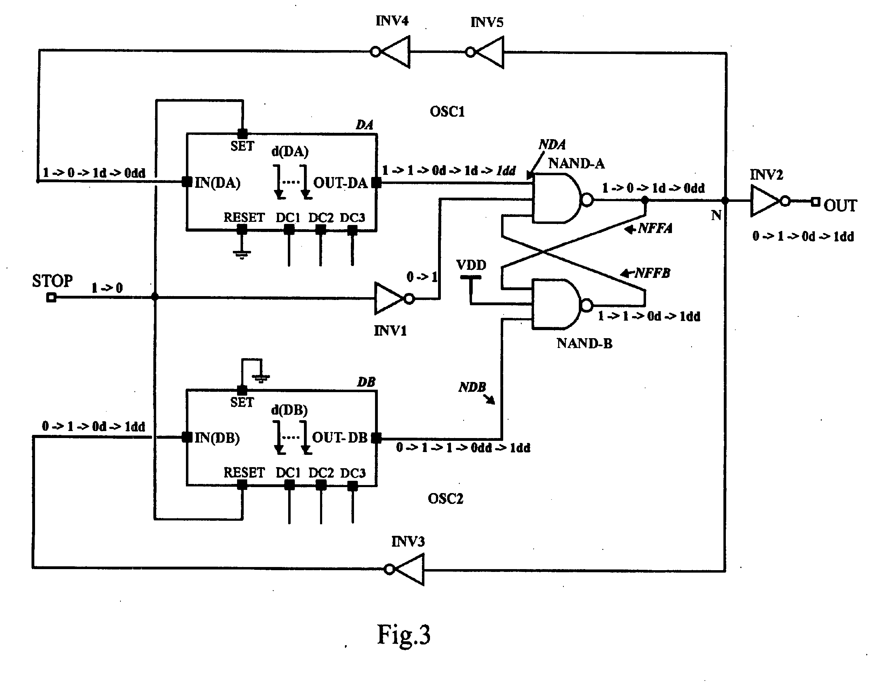

Referring to Figure 3, the generator circuit in accordance with the invention comprises two ring oscillators OSC1 and OSC2 having a common node N connected to the output terminal OUT of the circuit via a buffer that, in this particular example, is an inverter INV2. The oscillator OSC1 comprises two inverters INV4 and INV5 connected in cascade between the node N and the input IN(DA) of a delay element DA, in this example of a type capable of responding to an input pulse with a predetermined delay d(DA) with respect to the trailing edge of the input pulse and practically without delay with respect to the leading edge of this input pulse. The oscillator OSC2 comprises an inverter INV3 connected between the node N and the input IN(DB) of another delay element DB that is wholly similar to the delay element DA. The circuit also comprises a bistable logic circuit, or flip-flop, formed in this example by two NAND logic gates, indicated by NAND-A and NAND-B, connected to the two oscillators in such a way as to constitute an inverting element for one of the rings and two inverting elements for the other. More particularly, the gate NAND-A has its output connected to the common node N and the two gates have their respective outputs each connected to an input of the other NAND gate and each has another input connected to the output of, respectively, the delay element DA and the delay element DB; consequently, the flip-flop closes the ring of the oscillator OSC1 with one inverting element whenever it is in one of its two stable states and closes the ring of the oscillator OSC2 with two inverting elements whenever it is in the other of its two stable states. The flip-flop has a habilitation terminal constituted by a third input of the gate NAND-A. This third input is connected to the output of an inverter INV1 that has its input connected to an activation/deactivation control terminal, indicated by STOP. The gate NAND-B has a third input connected to a terminal to which there can be applied a fixed voltage, for example the supply voltage VDD of the circuit, so that it will always be in the logic state 1.

Each of the two delay elements DA and DB has an activation terminal, indicated by SET, and a deactivation terminal, indicated by RESET, that serve to force the respective outputs to 1 or to 0; more particularly, the output of one delay element is stable at the logic value 0 when the terminal RESET is at the logic value 1 or is stable at the logic value 1 when the terminal SET is at the logic value 1. In this example, the terminal SET of DA and the terminal RESET of DB are connected to the activation/deactivation terminal STOP and the terminal SET of DB and the terminal RESET of DA are connected to ground, so that, whenever STOP=1, the output of DA is stable at 1 and the output of DB is stable at 0, while, whenever STOP=0, both the output of DA and the output of DB depend on the state of their respective inputs. Each of the two delay elements DA and DB also has three other inputs, indicated by DC1, DC2 and DC3, which serve to set the delay, as will be explained in detail further on in this description. It is clear that, in general principle, the delays of the elements DA and DB may differ from each other.

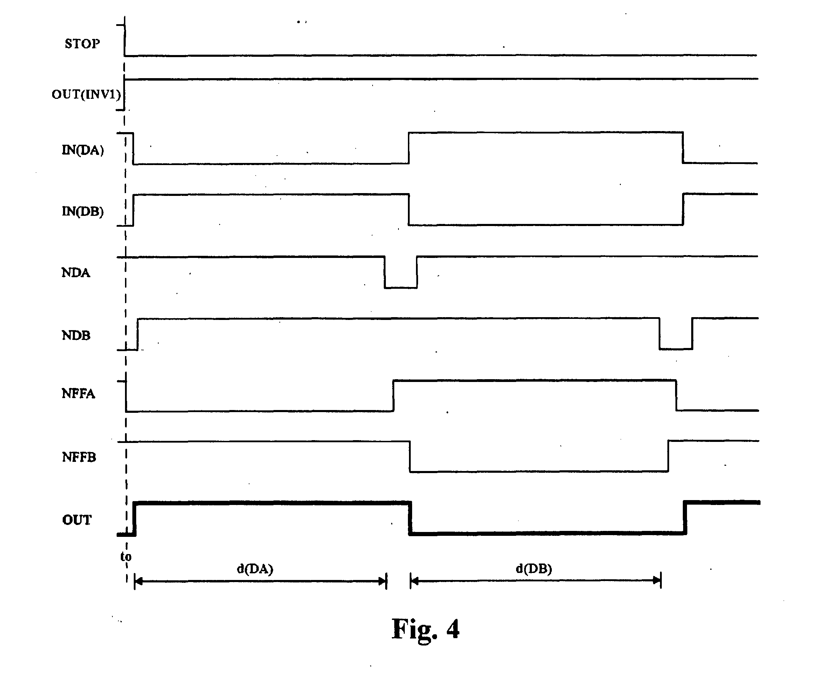

Let us now consider the functioning of the circuit of Figure 3 with reference to the waveforms of Figure 4, bearing in mind that the time relationships between the various waveforms shown in the figure are only indicative, because not all the delays associated with the various elements of the circuit have been taken into consideration in a rigorous manner. With a view to facilitating comprehension of the functioning, the logic states (0,1) of the principal nodes of the circuit are shown in succession, possibly followed by one or more letters "d" to indicate the delayed change of state.

The circuit becomes activated when the binary signal STOP changes state, passing from 1 to 0. For as long as STOP=1, the output NDA of the retarder element DA is equal to 1, because SET=1, the output NDB of the delay element DB is equal to 0, because RESET=1, the output NFFA of the gate NAND-A is equal to 1, because at least one of its two inputs, the one connected to the output of the inverter INV1, is equal to 0, the output NFFB of the gate NAND-B is equal to 1, because at least one of its two inputs, the one connected to the output of the delay element DB, is at 0, and the output OUT of the oscillator is equal to 0.

When STOP switches from 1 to 0 at the instant to, the two delay elements DA and DB are habilitated to respond to the signals applied to their respective inputs IN(DA) and IN(DB). It should be noted that, before STOP switches from 1 to 0, the input IN(DA), due to the double inversion of the signal present on NFFA, is equal to 1 and the input IN(DB), due to the inversion of the signal present on NFFA, is equal to 0. As soon as STOP=0, the output of INV1 (OUT(INV1)) switches from 0 to 1, so that the inputs of NAND-A are all at 1 (NFFB=1 and NDA remains unchanged at 1 for a period of time determined by the delay element DA), the output of NAND-A, i.e. NFFA, switches from 1 to 0 and the output OUT switches from 0 to 1. The input IN (DA) switches from 1 to 0, the input IN(DB) of DB switches from 0 to 1. The output of DB, i.e. NDB, switches from 0 to 1 after a brief delay with respect to the leading edge of the input signal IN(DB) and the output NFFB remains at 1 (because at least one of its inputs, the one connected to NFFA, is equal to 0). After a period of time equal to the delay d(DA) of DA, the output NDA of DA switches from 1 to 0, so that the output NFFA of NAND-A switches from 0 to 1, the output NFFB of NAND-B switches from 1 to 0, because its inputs are now all at 1 (NDB remains equal to 1 for a period of time d(DB) determined by the cell DB), OUT switches from 1 to 0, the input IN(DA) of DA switches from 0 to 1 and the output NDA of DA, which has just passed to 0, returns to 1 after a very brief period of time, because the delay of DA on the leading edge of the input is very brief, the input IN(DB) of DB switches from 1 to 0, while the output NDB remains at 1 for the whole of the delay time d(DB). When the delay d(DB) comes to an end, NDB switches to 0, NFFB switches to 1, NFFA switches to 0 (because the inputs of the gate NAND-A are now all at 1), OUT switches to 1, the input IN(DA) of DA switches to 0 and NDA remains at 1, the input IN(DB) of DB switches from 0 to 1, while the output NDB returns to 1 with the brief delay associated with the leading edge of the input signal. The network is now in the same conditions in which it was just after the instant to (at the begnning of the delay d(DA)) and continues to oscillate between the two states 0 and 1 for as long as STOP remains equal to 0. As soon as STOP switches from 0 to 1, the output NDA of the delay element DA switches to 1 and remains there and output NDB switches to 0 and remains there, so that we once again have the situation illustrated at the beginning of the description of the functioning of the circuit.

It should be noted that, if the oscillation is to be assured, all that is necessary is that the delay introduced by the two inverters INV4 and INV5, or the delay introduced by the inverter INV3, summed with the brief delay of one cell (DA or DB) with respect to the leading edge of a pulse at its input (switch from 0 to 1), should be greater than the switching time of the flip-flop.

It is clear from what has been explained above that the circuit of Figure 3 responds to a n activation signal (STOP=0) by immediately causing the output to switch (from 0 to 1) and generating, without any start-up transient, clock pulses of the pre-established period and duty cycle. The period is determined by the sum of the delays (d(DA)+d(DB)) of the delay elements DA and DB and the duty cycle is determined by the ratio between one of the two delays and the sum of the two delays.

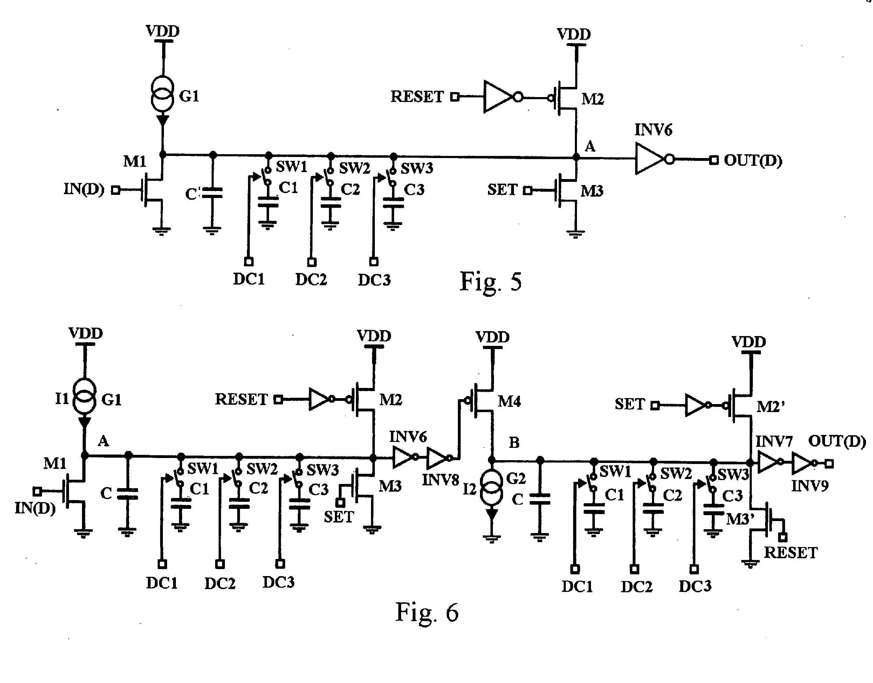

The delay elements may be circuits that respond to a predetermined edge of a binary input signal, that is to say, to a transition from one predetermined state of the two binary logic states to the other, with a delay that is a function of the ratio between a capacitance C and a current I. A known circuit of this type, in which the transition from 1 to 0 is delayed and in which this delay can be adjusted, is schematically illustrated by Figure 5. It comprises a group of capacitors (four in this example, but they could also be more or less than four) connected, or capable of being connected, to the input A of an inverter INV 6. The capacitors are connected between the node A and ground; more precisely, one of them, indicated by C, is connected directly between the node A and ground and the other three, indicated by C1, C2, C3, can be connected to the node A via respective electronic switches SW1, SW2 and SW3 controlled by binary logic signals applied to respective control terminals DC1, DC2, DC3. An N-channel MOS transistor, indicated by M1, and a constant current generator G1 connected in series with each other between the terminals of the supply source (ground and VDD) make it possible to control the charge of the capacitors. The input terminal IN(D) and the output terminal OUT(D) of the delay circuit are, respectively, the gate terminal of the transistor M1 and the output terminal of the inverter INV6. The node A, via an N-channel MOS transistor, indicated by M3, is also connected to ground, and, via a P-channel MOS transistor, indicated by M2, to the supply terminal VDD. The gate terminal of the transistor M3 is connected to an activation terminal SET of the delay circuit and the gate terminal of the transistor M2, via an inverter, is connected to a deactivation terminal RESET of the delay circuit.

According to a likewise known variant (not illustrated) of the delay circuit of Figure 5, the constant current generator G1 is replaced by a resistor, so that the delay is a function of the product of the resistance of the resistor multiplied by the capacitance of the capacitors connected to the input of the inverter.

Referring to the circuit of Figure 5, let us first consider the case in which SET=0 and RESET=0, i.e. the case in which both M3 and M2 are not conducting. When IN(D)=1, the transistor M1 conducts, so that the node A is substantially at ground potential (binary state 0), the capacitors connected to the node A are discharged and, due to the effect of the inverter INV6, the output OUT(D) of the delay circuit is a positive voltage, typically the supply voltage VDD (binary state 1). When the input signal IN(D) passes from 0 to 1, the transistor M1 ceases to conduct and the capacitors begin to charge through the generator G1. When the voltage at the node A attains the switching threshold voltage of the inverter INV6, the output OUT(D) of the delay circuit passes from the supply voltage VDD to ground potential. The time that elapses between the moment when the signal IN passes from 1 to 0 and the switching instant of the inverter, i.e. the delay time of the circuit, obviously depends on the threshold voltage of the inverter. The delay time may be modified by closing or opening one or more of the switches SW1, SW2, SW3 connecting the capacitors C1, C2, C3 to ground by means of signals applied to DC1, DC2, DC3. The output OUT(D) of the delay circuit may be forced to 1 or to 0 by using the alternative settings of RESET=0 and SET=1 or RESET=1 and SET=0.

The inverter INV6 typically consists of two complementary MOS transistors (i.e. an N-channel transistor and a P-channel transistor) that have their drain terminals in common and their source terminals connected, respectively, to the ground terminal and the positive terminal VDD of the supply source. In this case the threshold voltage depends on the supply voltage VDD, the threshold voltages of the transistors and the mobility of the charge carriers (electrons and vacancies) in the transistors. The supply voltage VDD may be fixed with a good degree of precision (+/-1%) at a nominal value established in the design phase, but the threshold voltages of the transistors and the mobility of the charge carriers cannot be accurately fixed, because they depend on manufacturing parameters, which may vary within relatively wide limits, and depend also on the operating temperature, which - in its turn - depends on the operating conditions of the device in which the time-delay circuit is integrated. With a view to avoiding these difficulties, use may be made of the circuit shown in Figure 6, which is based on a solution idea described in European Patent Application No.4425083.5 filed by the present applicant on 10 February 2004 under the title "Delay-time circuit".

The circuit shown in Figure 6 comprises an input stage, wholly identical with the circuit of Figure 5, that is coupled, by means of an inverter INV8, to a second stage that comprises a dual circuit of the one of Figure 5. More particularly, the second stage comprises a P-channel MOS transistor, indicated by M4, having its source terminal connected to the positive terminal VDD of the supply source and its drain terminal (node B) connected, via a constant current generator G2, to the negative terminal of the supply source, i.e. the ground terminal. The node B is connected to ground via an array of capacitors, that are equal to the capacitors of the input stage and are therefore indicated by the same reference numbers, and to the output terminal OUT(D) of the circuit via two inverters INV7 and INV9 in cascade. Two complementary MOS transistors M2' and M3', equal to the transistors M2 and M3 of the first stage, are connected to the node B to perform the same function as the transistors M2 and M3, with the sole difference that the signals SET and RESET are swapped.

When the input terminal IN(D) is equal to 1 (with SET=0 and RESET=0), the transistor M1 is conducting, the node A is at 0, the capacitors connected to the node A are discharged, the output of the inverter INV6 is at 1, the output of the inverter INV8 is at 0, the transistor M4 is conducting, the node B is at 1, the capacitors connected to the node B are charged at the voltage VDD, the output of the inverter INV7 is at 0 and the output OUT (D) is at 1. When the input IN(D) switches from 1 to 0, i.e. when M1 passes from conducting to blocking, the current I1 of the generator G1 charges the capacitors connected to the node A, causing the voltage of the node A to rise linearly (VA=I1*t/C1), where t is the time and CA is the capacitance of the capacitors). When, following a time Δt1, the threshold voltage of the inverter INV6 is attained, the output of the inverter INV6 switches from 1 to 0, the output of the inverter INV8 switches from 0 to 1, the transistor M4 switches to blocking and the capacitors connected to the node B become linearly discharged (VB=VDD-I2*t/CB, where t is the time, CB is the capacitance of the capacitors and I2 is the current of the generator G2. When, following a time Δt2, the node B reaches the threshold voltage of the inverter INV7, the latter switches from 0 to 1 and the output OUT(D) switches from 1 to 0. The time Δt that elapses between the moment the the signal IN(D) changes from 1 to 0 and the switching of the inverter INV9 is the delay time of the circuit and is substantially given by the sum of the two delays Δt1 and Δt2, i.e. the sum of the time that is needed for the current I1 to charge the capacitors connected to the node A from 0 (ground potential) to the threshold voltage Vth(INV6) of the inverter INV6 and the time that is needed for the current I2 to discharge the capacitors connected to the node B from the voltage VDD to the threshold voltage Vth(INV7) of the inverter INV7. When the circuit is designed in such a manner that I1=I2=I, CA=CB=C, Vth (INV6)=Vth(INV7), the total delay time of the circuit is determined solely by the time needed for a constant current I to charge a capacitor of capacitance C from 0 to VDD. The delay time is thus independent of the threshold voltage of the inverters and therefore insensitive to the variations deriving from the manufacturing process and the temperature. There remains the dependence on the supply voltage, but, as already mentioned, this can easily be maintained at a substantially constant nominal value.

As is well known to persons skilled in the design of integrated circuits, the conditions of equality indicated above can be obtained with a good degree of precision. In particular, the generators G1 and G2 may be constituted by branches of respective equal current mirrors that mirror a fixed reference current independent of the temperature and the inverters may be constituted by identical components, since they are of the same size and are made by means of the same manufacturing process. It is in any case clear to a person skilled in the art that the same result may, as a general rule, be obtained with different current generators, capacitors and inverters, always provided that the equalities I1/CA=I2/CB and Vth(INV6)=Vth(INV7) are substantially satisfied.

It is obvious that the inverter INV9 serves only for obtaining at the output terminal a clock signal having the same sign as the input signal. When a clock signal of the opposite sign is desired, this inverter may be omitted: in that case the output of the circuit coincides with the output of the inverter INV7.

A dual circuit (not here illustrated) of the one shown in Figure 6 utilizes a P-channel MOS transistor rather than an N-channel MOS transistor and an N-channel MOS transistor rather than a P-Channel MOS transistor; these transistors have their respective source terminals connected to the supply terminals dual to those of the corresponding transistors of the circuit of Figure 6. With this configuration the delay time Δt of the output is relative to the leading edge of the input signal rather than the trailing edge. The functioning of this circuit is wholly analogous to the functioning of the circuit of Figure 6, for which reason it will not here be further described.

The circuit of Figure 6 and its dual can be modified, as already noted in relation to the circuit of Figure 5, by including two resistors in place of the constant current generators G1 and G2. In this case, once again, the delay time will be given by the sum of the delay times of the two stages, each of which is a function of the respective resistances and capacitances.

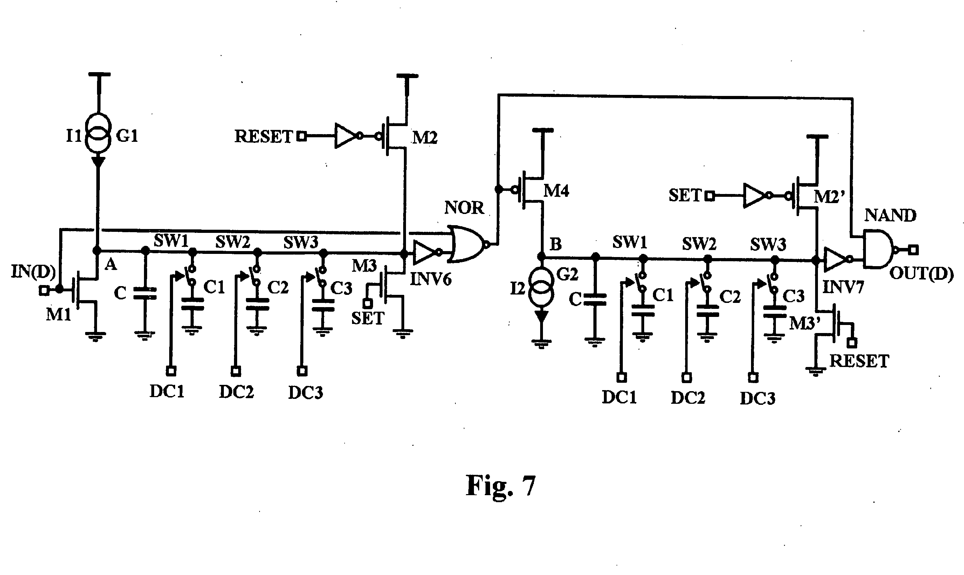

Figure 7 shows a variant of the delay-time circuit of Figure 6 to be used in case it becomes necessary to reduce to the greatest possible extent the noise that the oscillator containing the delay-time circuit may induce in the supply voltages. It is well known that an oscillator realized in an integrated circuit that contains analog circuits can cause interference in the supply voltages of the analog circuits. This interference is proportional to the currents in play. The delay time of each of the delay elements utilized in the oscillator must be the briefest possible at a predetermined edge of the input pulse. Once the capacitance of the capacitors has been fixed, a reduction of this delay time requires one to diminish the resistance in conduction of the transistors (M1, M4) through which the capacitors are discharged. However, a low resistance implies a large discharge current and therefore considerable interference. The variant of the delay-time circuit shown in Figure 7 makes it possible to maintain the resistance of the transistors at a relatively high value, thus avoiding high current peaks, while yet obtaining the very brief delay time.

The circuit of Figure 7 differs from the one of Figures 6 by virtue of the fact that the place of the inverters INV8 and INV 9 is taken by, respectively, a NOR gate and a NAND gate. The NOR gate has a first input connected to the output of the inverter INV6 and a second input connected to the input of the first stage, i.e. the input terminal IN(D) of the circuit. The NAND gate has a first input connected to the output of the inverter INV7 and a second input connected to the input of the second stage, i.e. the gate terminal of the transistor M4. As regards the functioning, when IN(D) switches to 1, the transistor M1 goes from blocking to conducting, so that the capacitors connected to the node A begin to discharge through it. Before the discharge is completed, however, the switching of the input signal forces the output OUT(D) to 1. In fact, the logic constituted by the NOR gate and the NAND gate transmits the switching of the input to the output before the capacitors become charged/discharged. All that is needed is that the discharging/charging processes should be concluded in a time shorter than the half-period of the oscillation.

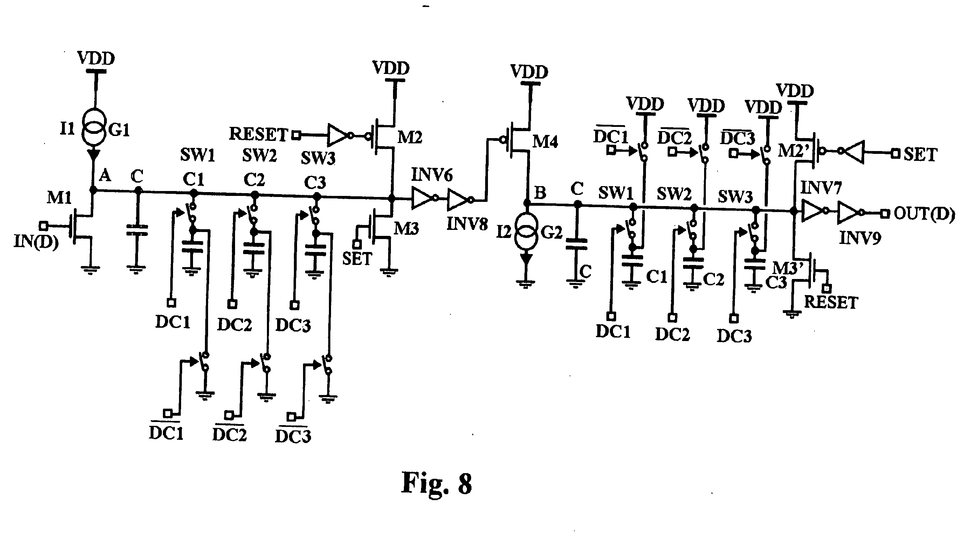

Lastly, Figure 8 shows a variant of the delay-time circuit of Figure 6 to be utilized when it is desired to modify the duty cycle and or the period of the output signal during the functioning of the generator. If the contribution of each capacitor is always to be the same whenever the respective electronic switch is closed, it is essential that its initial charging conditions should always be the same. Consequently, the capacitors of the input stage are maintained at ground potential when they are not connected to the node A and the capacitors of the output stage are maintained at VDD when they are not connected to the node B, utilizing electronic switches controlled by the negated values of the binary signal DC1, DC2, DC3.

To conclude, one may note from what has been explained above the clock-pulse generator circuit in accordance with the invention produces an oscillation that can be utilized as soon as the oscillator is started, because it is not affected by transient phenomena. When it is brought to a halt (STOP=1), in fact, it stops in a known condition, that is to say, all its nodes always assume the same predetermined binary values; consequently, when it is re-started (STOP=0), it begins with an oscillation of the correct value right from the first half-period.

In a particular embodiment of the invention the circuit generates clock pulses having a period and a duty cycle substantially independent of the variations due to the manufacturing process of the integrated circuit and the operating temperature.

According to another embodiment of the invention, the generator may be realized in such a manner as to avoid high current peaks and it is therefore suitable for being used with advantage in integrated circuits in which it is desired to avoid the risk of inducing noise in the supply voltages.

Furthermore, both the period and the duty cycle of the output signal of the generator may be modified within wide limits. This adjustment is possible at any moment even while the generator is in operation.

## Claims

1. A clock-pulse generator circuit comprising an output terminal (OUT) and capable of providing at said terminal (OUT), in response to an activation signal (STOP), a clock signal, said clock-pulse generator circuit comprising:
- a first ring oscillator (OSC1) comprising an odd number of inverting elements, a delay element (DA) and an output terminal (N), the delay element being capable of responding to a pulse at its input (IN-DA) with a predetermined time delay (d(DA)) with respect to a predetermined edge of the input pulse and substantially without time delay with respect to the other edge of the input pulse,
**characterized in that** it comprises
- a second ring oscillator (OSC2) comprising an odd number of inverting elements, a delay element (DB) and an output terminal connected to the output terminal (N) of the first oscillator, the delay element (DB) being capable of responding to a pulse at its input (IN-DB) with a predetermined time delay (d(DB)) with respect to a predetermined edge of the input pulse and substantially without delay time with respect to the other edge of the input pulse and
- a bistable logic circuit (NAND-A, NAND-B) having an output terminal connected to the common output terminal (N) of the first and the second oscillator, said bistable logic circuit being such as to close the ring of the first ring oscillator (OSC1) whenever it is in one of its two stable states and to close the ring of the second ring oscillator whenever it is in the other of its two stable states;
- and **in that** at least one of the inverting elements of the first oscillator (OSC1) and at least one of the inverting elements of the second oscillator (OSC2) form part of the bistable logic circuit.

2. A circuit in accordance with Claim 1, wherein at least one of the delay elements (DA, DB) of the first and the second oscillator comprises means for adjusting the time delay (DC1, DC2, DC3).

3. A circuit in accordance with Claim 1 or Claim 2, wherein each of the delay elements (DA, DB) of the first and the second oscillator comprises setting means capable of stably maintaining the respective outputs (NDA, NDB) in a predetermined binary state, said setting means being such that they can be activated and deactivated with a respective digital signal (SET, RESET).

4. A circuit in accordance with any one of the preceding claims, wherein the bistable logic circuit comprises an activation/deactivation terminal.

5. A circuit in accordance with any one of the preceding claims, wherein the bistable logic circuit has an input terminal (NDA) connected to the output terminal (OUT-DA) of the delay element (DA) of the first oscillator (OSC1) and a second input terminal (NDB) connected to the output terminal (OUT-DB) of the delay element (DB) of the second oscillator (OSC2).

6. A circuit in accordance with any one of the preceding claims, wherein each of the delay elements (DA, DB) comprises
- an input terminal (IN(D)) and an output terminal (OUT(D)),
- a first inverter (INV6) having a particular switching threshold voltage, capacitive means (C, C1, C2, C3) connected to the input terminal (A) of the first inverter,
- means (M1, G1) for controlling the charge of the capacitive means capable of responding to a predetermined edge of a pulse applied to the input terminal (IN(D)) of the delay element to bring the input terminal of the first inverter (INV6) from a first predetermined voltage to the switching threshold voltage and obtain at the output terminal of the first inverter a pulse having an edge that, with respect to the predetermined edge of the input pulse, has a first time delay that depends on the switching threshold voltage,
and wherein the means for adjusting the time delay comprise
- means (SW1, SW2, SW3, C1, C2, C3) for modifying the capacitance of the capacitive means as a function of the signals applied to the respective adjustment inputs (DC1, DC2, DC3) of the delay element.

7. A circuit in accordance with Claim 3, wherein the adjustment means comprise two electronic switches (M2, M3) capable of connecting the input terminal (A) of the inverter (INV6) to a first or a second voltage reference terminal in response to digital signals (SET, RESET) applied to the respective activation/deactivation terminals.

8. A circuit in accordance with Claim 6, wherein each of the delay elements (DA, DB) comprises a stage having an input terminal coupled with the output terminal of the first inverter (INV6) and an output terminal coupled with the output terminal (OUT(D)) of the delay element, said stage comprising
- a second inverter (INV7) having a switching threshold voltage that is substantially equal to that of the first inverter (INV6) and an output terminal that is the output terminal of the stage,
- further capacitive means (C, C1, C2, C3) connected to the input terminal (B) of the second inverter (INV7) and
- means (M4, G2) for controlling the charge of the further capacitive means capable of responding to the delayed edge of the pulse present at the output terminal of the first inverter (INV6) to bring the input terminal of the second inverter (INV7) from a second predetermined voltage (VDD) to the switching threshold voltage and obtain on the output terminal of the second inverter (INV7) a pulse having an edge that, with respect to the delayed edge of the output pulse of the first inverter, has a second time delay that depends on the switching threshold voltage, the overall time delay (d(DA), d(DB)) of the delay element (DA, DB) being the sum of the first and the second time delay.

9. A circuit in accordance with Claim 6, wherein the means for modifying the capacitance of the capacitive means comprise a multiplicity of capacitors (C1, C2, C3) and a multiplicity of electronic switches (SW1, SW2, SW3) each connected in series with one of the capacitors and controlled by the signals applied to the respective adjustment inputs (DC1, DC2, DC3).

10. A circuit in accordance with Claim 8, wherein each of the delay elements (DA, DB) comprises logic bypass means (NOR, NAND) connected in such a manner as to transmit to the output (OUT(D)) a switch from one logic state to the other of an input pulse in a time less than a half-period of oscillation.

## Patentansprüche

1. Taktimpulsgenerator-Schaltung mit einem Ausgangsanschluß (OUT) und geeignet zum Bereitstellen eines Taktsignals an diesem Anschluß (OUT) als Antwort auf ein Aktivierungssignal (STOP), wobei die Taktimpulsgenerator-Schaltung aufweist:
- einen ersten Ringoszillator (OSC1), der eine ungerade Anzahl von Invertierungselementen, ein Verzögerungselement (DA) und einen Ausgangsanschluß (N) aufweist, wobei das Verzögerungselement in der Lage ist, auf einen Puls an seinem Eingang (IN-DA) mit einer vorgegebenen Zeitverzögerung (d(DA)) bezüglich einer vorgegebenen Flanke des Eingangspulses und im wesentlichen ohne Zeitverzögerung bezüglich der anderen Flanke des Eingangspulses zu antworten,
**dadurch gekennzeichnet, daß** sie aufweist:
- einen zweiten Ringoszillator (OSC2), der eine ungerade Anzahl von Invertierungselementen, ein Verzögerungselement (DB) und einen Ausgangsanschluß aufweist, der mit dem Ausgangsanschluß (N) des ersten Oszillators verbunden ist, wobei das Verzögerungselement (DB) in der Lage ist, auf einen Puls an seinem Eingang (IN-DB) mit einer vorgegebenen Zeitverzögerung (d(DB)) bezüglich einer vorgegebenen Flanke des Eingangspulses und im wesentlichen ohne Zeitverzögerung bezüglich der anderen Flanke des Eingangspulses zu antworten, und
- eine bistabile Logikschaltung (NAND-A, NAND-B), die einen mit dem gemeinsamen Ausgangsanschluß (N) des ersten und zweiten Oszillators verbundenen Ausgangsanschluß hat, wobei die bistabile Logikschaltung derart ist, um den Ring des ersten Ringoszillators (OSC1) immer dann zu schließen, wenn sie in einem ihrer zwei stabilen Zustände ist, und den Ring des zweiten Ringsoszillators immer dann zu schließen, wenn sie in dem anderen ihrer zwei stabilen Zustände ist;
- und dadurch, daß mindestens eines der Invertierungselemente des ersten Oszillators (OSC1) und mindestens eines der Invertierungselemente des zweiten Oszillators (OSC2) Teil der bistabilen Logikschaltung bilden.

2. Schaltung nach Anspruch 1, wobei mindestens eines der Verzögerungselemente (DA, DB) des ersten und des zweiten Oszillators Einrichtungen (DC1, DC2, DC3) zum Einstellen der Verzögerungszeit aufweist.

3. Schaltung nach Anspruch 1 oder Anspruch 2, wobei jedes der Verzögerungselemente (DA, DB) des ersten und des zweiten Oszillators Setzeinrichtungen aufweist, die die jeweiligen Ausgänge (NDA, NDB) stabil in einem vorgegebenen binären Zustand halten können, wobei die Setzeinrichtungen derart sind, daß sie mit einem jeweiligen digitalen Signal (SET, RESET) aktiviert und deaktiviert werden können.

4. Schaltung nach einem der vorstehenden Ansprüche, wobei die bistabile Logikschaltung einen Aktivierungs/Deaktivierungsanschluß aufweist.

5. Schaltung nach einem der vorstehenden Ansprüche, wobei die bistabile Logikschaltung einen mit dem Ausgangsanschluß (OUT-DA) des Verzögerungselements (DA) des ersten Oszillators (OSC1) verbundenen Eingangsanschluß (NDA) und einen mit dem Ausgangsanschluß (OUT-DB) des Verzögerungselements (DB) des zweiten Oszillators (OSC2) verbundenen zweiten Eingangsanschluß (NDB) hat.

6. Schaltung nach einem der vorstehenden Ansprüche, wobei jedes der Verzögerungselemente (DA, DB) aufweist:
- einen Eingangsanschluß (IN(D)) und einen Ausgangsanschluß (OUT(D)),
- einen ersten Invertierer (INV6) mit einer speziellen Schaltschwellenspannung, mit dem Eingangsanschluß (A) des ersten Invertierers verbundene Kapazitätseinrichtungen (C, C1, C2, C3),
- Einrichtungen (M1, G1) zur Steuerung der Ladung der Kapazitätseinrichtungen und in der Lage, auf eine vorgegebene Flanke eines an dem Eingangsanschluß (IN(D)) des Verzögerungselements anliegenden Pulses zu antworten, um den Eingangsanschluß des ersten Invertierers (INV6) von einer ersten vorgegebenen Spannung auf die Schaltschwellenspannung zu bringen und an dem Ausgangsanschluß des ersten Invertierers einen Puls zu erhalten, der eine Flanke hat, die bezüglich der vorgegebenen Flanke des Eingangspulses eine erste Zeitverzögerung hat, die von der Schaltschwellenspannung abhängt,
und wobei die Einrichtungen zum Einstellen der Zeitverzögerung aufweisen:
- Einrichtungen (SW1, SW2, SW3, C1, C2, C3) zum Modifizieren der Kapazität der Kapazitätseinrichtungen als eine Funktion der an den jeweiligen Einstellungseingängen (DC1, DC2, DC3) des Verzögerungselements anliegenden Signale.

7. Schaltung nach Anspruch 3, wobei die Einstellungseinrichtungen zwei elektronische Schalter (M2, M3) aufweisen, die in der Lage sind, als Antwort auf digitale Signale (SET, RESET), die an den jeweiligen Aktivierungs/Deaktivierungsanschlüssen anliegen, den Eingangsanschluß (A) des Invertierers (INV6) mit einem ersten oder einem zweiten Spannungsreferenzanschluß zu verbinden.

8. Schaltung nach Anspruch 6, wobei jedes der Verzögerungselemente (DA, DB) eine Stufe aufweist, die einen mit dem Ausgangsanschluß des ersten Invertierers (INV6) verbundenen Eingangsanschluß und einem mit dem Ausgangsanschluß (OUT(D)) des Verzögerungselements verbundenen Ausgangsanschluß hat, wobei die Stufe aufweist:
- einen zweiten-Invertierer (INV7) mit einer Schaltschwellenspannung, die im wesentlichen gleich derjenigen des ersten Invertierers (INV6) ist, und mit einem Ausgangsanschluß, der der Ausgangsanschluß der Stufe ist,
- weitere Kapazitätseinrichtungen (C, C1, C2, C3), die mit dem Eingangsanschluß (B) des zweiten Invertierers (INV7) verbunden sind, und
- Einrichtungen (M4, G2) zur Steuerung der Ladung der weiteren Kapazitätseinrichtungen und in der Lage, auf die verzögerte Flanke des an dem Ausgangsanschluß des ersten Invertierers (INV6) vorhandenen Pulses zu antworten, um den Eingangsanschluß des zweiten Invertierers (INV7) von einer zweiten vorgegebenen Spannung (VDD) auf die Schaltschwellenspannung zu bringen und an dem Ausgangsanschluß des zweiten Invertierers (INV7) einen Puls zu gewinnen, der eine Flanke hat, die bezüglich der verzögerten Flanke des Ausgangspulses des ersten Invertierers eine zweite Zeitverzögerung hat, die von der Schaltschwellenspannung abhängt, wobei die gesamte Zeitverzögerung (d(DA), d(DB)) des Verzögerungselements (DA, DB) die Summe der ersten und zweiten Zeitverzögerung ist.

9. Schaltung nach Anspruch 6, wobei die Einrichtungen zum Modifizieren der Kapazität der Kapazitätseinrichtungen mehrere Kondensatoren (C1, C2, C3) und mehrere elektronische Schalter (SW1, SW2, SW3) aufweisen, die jeweils in Reihe mit einem der Kondensatoren verbunden sind und von den an den jeweiligen Einstellungseingängen (DC1, DC2, DC3) anliegenden Signalen gesteuert werden.

10. Schaltung nach Anspruch 8, wobei jedes der Verzögerungselemente (DA, DB) logische Bypass-Einrichtungen (NOR, NAND) aufweist, die derart verbunden sind, um in einer Zeit, die kleiner als eine halbe Oszillationsperiode ist, zu dem Ausgang (OUT(D)) eine Umschaltung von dem einen Logikzustand eines Eingangspulses in den anderen zu übertragen.

## Revendications

1. Circuit générateur d'impulsions d'horloge comprenant une borne de sortie (OUT) et pouvant fournir à ladite borne (OUT), en réponse à un signal d'activation (STOP), un signal d'horloge, ledit circuit générateur d'impulsions d'horloge comprenant :
- un premier oscillateur en anneau (OSC1) comprenant un nombre impair d'éléments inverseurs, un élément à retard (DA) et une borne de sortie (N), l'élément à retard étant capable de répondre à une impulsion à son entrée (IN-DA) avec un temps de retard prédéterminé (d(DA) par rapport à un front prédéterminé de l'impulsion d'entrée et substantiellement sans temps de retard par rapport à l'autre front de l'impulsion d'entrée,
**caractérisé en ce qu'**il comprend
- un second oscillateur en anneau (OSC2) comprenant un nombre impair d'éléments inverseurs, un élément à retard (DB) et une borne de sortie connectée à la borne de sortie (N) du premier oscillateur, l'élément à retard (DB) étant capable de répondre à une impulsion à son entrée (IN-DB) avec un temps de retard prédéterminé (d(DB)), par rapport à un front prédéterminé de l'impulsion d'entrée et substantiellement sans temps de retard par rapport à l'autre front de l'impulsion d'entrée et
- un circuit logique bistable (NAND-A, NAND-B) ayant une borne de sortie connectée à la borne de sortie commune (N) des premier et second oscillateurs, ledit circuit logique bistable étant tel qu'il ferme l'anneau du premier oscillateur en anneau (OSC1) chaque fois qu'il est dans un de ses deux états stables et qu'il ferme l'anneau du second oscillateur en anneau chaque fois qu'il est dans l'autre de ses deux états stables;
- et **en ce qu'**au moins un des éléments inverseurs du premier oscillateur (OSC1) et au moins un des éléments inverseurs du deuxième oscillateur (OSC2) forment une partie du circuit logique bistable.

2. Circuit conformément à la revendication 1, dans lequel au moins un des éléments à retard (DA, DB) du premier et du second oscillateurs comprend des moyens permettant de régler le temps de retard (DC1, DC2, DC3).

3. Circuit selon la revendication 1 ou la revendication 2, dans lequel chacun des éléments à retard (DA, DB) du premier et du second oscillateurs comprend des moyens de paramétrage capables de maintenir de façon stable les sorties respectives (NDA, NDB) dans un état binaire prédéterminé, lesdits moyens de paramétrage étant tels qu'ils peuvent être activés et désactivés avec un signal numérique respectif (SET, RESET).

4. Circuit selon l'une quelconque des revendications précédentes, dans lequel le circuit logique bistable comprend une borne d'activation/de désactivation.

5. Circuit selon l'une quelconque des revendications précédentes, dans lequel le circuit logique bistable a une borne d'entrée (NDA) connectée à la borne de sortie de l'élément à retard (OUT-DA) du premier oscillateur (OSC1) et une second borne d'entrée (NDB) connectée à la borne de sortie (OUT-DB) de l'élément à retard (DB) du second oscillateur (OSC2).

6. Circuit selon l'une quelconque des revendications précédentes, dans lequel chacun des éléments à retard (DA, DB) comprend
- une borne d'entrée (IN(D)) et une borne de sortie (OUT(D)),
- un premier inverseur (INV6) ayant une tension de seuil de commutation particulière, des moyens capacitifs (C, C1, C2, C3) connectés à la borne d'entrée (A) du premier inverseur,
- des moyens (M1, G1) permettant de commander la charge des moyens capacitifs capables de répondre à un front prédéterminé d'une impulsion appliquée à la borne d'entrée (IN(D)) de l'élément à retard afin de faire passer la borne d'entrée du premier inverseur (INV6) d'une première tension prédéterminée à la tension de seuil de commutation et d'obtenir au niveau de la borne de sortie du premier inverseur une impulsion ayant un front qui, par rapport au front prédéterminé de l'impulsion d'entrée présente un premier retard qui dépend de la tension de seuil de commutation,
et dans lequel les moyens permettant de régler le retard comprennent
- des moyens (SW1, SW2, SW3, C1, C2, C3) permettant de modifier la capacité des moyens capacitifs en fonction des signaux appliqués aux entrées de réglage respectives (DC1, DC2, DC3) de l'élément à retard.

7. Circuit selon la revendication 3, dans lequel les moyens de réglage comprennent deux commutateurs électroniques (M2, M3) capables de connecter la borne d'entrée (A) de l'inverseur (INV6) à une première ou seconde borne de référence de tension en réponse aux signaux numériques (SET, RESET) appliqués aux bornes respectives d'activation/de désactivation.

8. Circuit selon la revendication 6, dans lequel chacun des éléments à retard (DA, DB) comprend un étage ayant une borne d'entrée couplée à la borne de sortie du premier inverseur (INV6) et une borne de sortie couplée à la borne de sortie (OUT(D) de l'élément à retard, ledit étage comprenant
- un second inverseur (INV7) ayant une tension de seuil de commutation qui est substantiellement égale à celle du premier inverseur (INV6) et une borne de sortie qui est la borne de sortie de l'étage,
- des moyens capacitifs supplémentaires (C, C1, C2, C3) connectés à la borne d'entrée (B) du second inverseur (INV7) et
- des moyens (M4, G2) permettant de commander la charge des moyens capacitifs supplémentaires capables de répondre au front retardé de l'impulsion présente à la borne de sortie du premier inverseur (INV6) afin de faire passer la borne d'entrée du second inverseur (INV7) d'une seconde tension prédéterminée (VDD) à la tension de seuil de commutation et d'obtenir sur la borne de sortie du second inverseur (INV7), une impulsion ayant un front qui, par rapport au front retardé de l'impulsion de sortie du premier inverseur présente un second retard qui dépend de la tension de seuil de commutation, le retard global (d(DA), d(DB)) de l'élément à retard (DA, DB) étant la somme du premier et du second retard.

9. Circuit selon la revendication 6, dans lequel les moyens permettant de modifier la capacité des moyens capacitifs comprennent une multiplicité de condensateurs (C1, C2, C3) et une multiplicité de commutateurs électroniques (SW1, SW2, SW3) connectés chacun en série avec un des condensateurs et commandés par les signaux appliqués aux entrées de réglage respectives (DC1, DC2 , DC3).

10. Circuit selon la revendication 8, dans lequel chacun des éléments à retard (DA, DB) comprend des moyens de dérivation logique (NOR, NAND) connectés de manière à transmettre à la sortie (OUT(D)) une commutation d'un état logique à un autre d'une impulsion d'entrée dans un temps inférieur à une demi-période d'oscillation.
